# DEMANDE DE BREVET EUROPEEN

(11) **EP 1 093 331 A2**
(43) Date de publication de la demande: **18.04.2001**
(21) Numéro de dépôt: 00121085.5
(22) Date de dépôt: 28.09.2000
(51) Int. Cl.: H05K 5/06

(54) **Boîtier pour abriter des composants électriques**

(30) Priorité: 14.10.1999 DE 29918158 U
(71) Demandeur: GUMMI-JÄGER KG GMBH & CIE, D-30625 Hannover (DE)
(72) Inventeur: Rust, Axel, 31515 Wunstorf (DE)
(74) Mandataire: Depmeyer, Lothar

(57) **Zusammenfassung**

Die Erfindung betrifft eine Gehäuse zur Aufnahme elektrischer Elemente, wobei die auf dem Gehäuseunterteil angeordnete, ringförmige, verformbare Dichtung durch Auflegen des Deckels elastissch verformbar und mit einer oder mehreren vorspringenden Rippen versehen ist. Um ungewollte Lageveränderungen der Dichtung insb. beim Schliessen des Gehäuses auszuschliessen, ist erfindungsgemäß vorgesehen, den mit den Rippen versehenen Teil der Dichtung mit einem Querschnittsteil festhaftend verbunden, der gegenüber dem anderen Querschnittsteil wesentlich härter eingestellt ist, wobei die Rippen gegenüber dem härteren Teil zur Verformung durch den Deckel beim Verschließen des Gehäuses vorspringen.

## Description

Die Erfindunng betrifft ein verschliessbares, mit einem Deckel versehenes Gehäuse zur Aufnahme elektrischer Elemente, wobei die auf dem Gehäuseunterteil angeordnete, ringförmige, aus einem Elastomer bestehende Dichtung durch Auflegen des Deckels bzw. Schliessen des Gehäuses elastisch verformbar und mit einer oder mehreren vorspringenden Rippen oder Wülsten versehen ist.

Unter elektrischen Elementen sollen hierbei auch elektromechanische und elektronische Bau- und Schaltelemente z.B. auch Platinen verstanden werden, die in Baugruppen zusammengefasst sein können.

Elektrische Elemente sind besonders empfindlich, und zwar insb. gegen Feuchtigkeit und kleinste Fremdkörper. Es ist ferner wichtig, daß die Gehäusedichtung als solche nicht nur wirkungsvoll ist, sondern auch die Gewähr bietet, daß eine einwandfreie Wirkungsweise auch dann gegeben ist, wenn unter allen nur möglichen Betriebsbedingungen das Gehäuse z. B. auch von Ungeübten geöffnet bzw. geschlossen werden muss.

Damit diese Forderungen erfüllt werden können, muss die Dichtung gegen ungewollte Lageveränderungen gesichert sein. Diese Forderung kann nach bekannten Vorschlägen durch eine Lagerung der Dichtung in einer Nut erfolgen, die jedoch besondere bauliche Vorkehrungen am Gehäuseunterteil verlangt. Aufgrund der Erfindung soll hier Abhilfe geschaffen werden und demgemäss ein Gehäuse der eingangs erwähnten Art vorgeschlagen werden, das den Forderungen im Hinblick auf Abdichtung, Bedienbarkeit, Lebensdauer und Aufbau gerecht wird.

Zur Lösung dieser Aufgabe ist erfindungsgemäss der mit den Rippen bzw. Wülsten versehene Teil des Querschnitts der Dichtung mit einem Querschnittsteil vorzugsweise festhaftend verbunden, der aus einem gegenüber dem anderen Querschnittsteil wesentliche härter eingestellten Elastomer besteht, der sich zweckmässigerweise an einem Rand, und zwar vorzugsweise an dem Rand befindet, der dem Inneren des Gehäuses zugekehrt ist.

Bei dieser aus zwei unterschiedlich hart ausgeführten Elastomerdichtung dient der härtere Teil der Stabilisierung und Halterung des weicher eingestellten Teils, dessen Rippen bzw. Wülste durch Schliessen des Gehäusedeckels verformt werden und so die Abdichtung herbeiführen.

Eine so ausgeführte Dichtung eröffnet auch die Möglichkeit, auf Nuten zur Aufnahme des Dichtungselementes ganz zu verzichten. So kann bei einer Anordnung des härteren Teils am inneren Umfang des Dichtungsringes die Auflagefläche für die Dichtung nach innen bzw. in Richtung auf das Gehäuseinnere gerade und eben auslaufen, wodurch das Gehäuse einfacher gestaltet werden und auch die Dichtung einfacher montiert bzw. einfacher ausgewechselt werden kann.

Weitere Einzelheiten der Erfindung werden anhand der Zeichnung erläutert, in der ein Ausführungsbeispiel der Erfindung dargestellt ist.

Es zeigen :
Fig. 1 einen Randabschnitt eines schematisch wiedergegebenen Gehäuses zur Aufnahme elektronischer Bauteile im Querschnitt,
Fig. 2 die für das Gehäuse gemäss Fig. 1 bestimmte Dichtung im Querschnitt, und zwar im unverformten Zustand, also bei noch nicht aufgebrachtem Deckel und
Fig. 3 eine gegenüber Fig. 2 abgewandelte Dichtung im Teilquerschnitt.

Das Gehäuse besteht im wesentlichen aus einem napfartigen Unterteil 1 mit einem Boden 2, Seitenwänden 3 und einem abgewinkelten Rand 4, vor dem sich - vom Inneren 8 des Gehäuses gesehen - eine parallel zum Boden 2 bzw. Rand 4 verlaufende, umlaufende, ebene Sitzfläche 5 für die in Fig. 2 näher wiedergegebene Dichtung 6 befindet, sowie einem Deckel 20. Dabei geht die Sitzfläche 5 über eine Stufe 7 in den Rand 4 über; zum Inneren 8 des Unterteils 1 geht allerdings die ebene Sitzfläche 5 stufenfrei unmittelbar in die Seitenwände 3 über.

Die ringförmig endlose Dichtung 6 besteht aus einem an ihrem äussern Umfang befindlichen, weich eingestellten Querschnittsteil 9 (Gummi oder gummiähnlicher Kunststoff) und einem am inneren Umfang befindlichen härter eingestellten Teil 10 mit zähharten Eigenschaften ( aus einem Thermo- oder Duroplast, ggfs. aber auch aus einem entsprechend steif eingestellten Kautschuk). Beide Querschnittseile 9, 10 sind festhaftend miteinander verbunden.

Die insg. im Querscnitt praktisch flach rechteckige Dichtung 6 ist jedoch insg. noch verformbar bzw. biegsam. Die Härteunterschiede sollen etwa 15 - 35 Shore Grade A betragen, wobei der härtere Querschnittsteil 10 eine Shore-Härte von etwa 70 - 90 erhalten soll.

Um die Haftfläche zwischen den beiden Querschnittsteilen 9 und 10 zu vergrössern, übergreift der Querschnittteil 9 den härteren Querschnittsteil 10, dazu ist der härtere Teil 10 bei 11 gestuft.

Der weichere Teil 9 weist an seiner Oberseite umlaufende Wlste 12 auf und an seiner Unterseite durch Umfangswülste gebildete Ausweichräume 13. Die Wülste 12 überragen dabei die durch die Oberseite des härteren Teil 10 bestimmte Ebene 14'. Soll nunmehr das Gehäuse 1 geschlossen werden, so beaufschlagt der Deckel 20 die Wülste 12 unter Verkleinerung der Ausweichräume 13. Diese Beaufschlagung ist durch die Pfeile 14 aufgezeigt.

Bei der Schliessbewegung die durch die Verschraubung 15 erzwungen werden kann, kann der Querschnittsteil 9 radial nach innen nicht ausweichen, weil der härtere Querschnittsteil 10 eine solche Verformung verhindert. Eine Fluchtbewegung in Richtung des Pfeiles L ist also praktisch nicht möglich.

Bei der Ausführung gemäss Zeichnung befindet sich der härtere, zäher angelegte Querschnittsbereich 10 am inneren Umfang der Dichtung 6. Ggfs. kann dieser aber auch am äusseren Umfang oder aber auch am inneren und äusseren Umfang angeordnet sein. Wichtig ist dabei, dass ungewollte Lateral- bzw. Ausweichbewegungen aufgrund der durch den Ring in Form des Querschnitteils 10 verhindert bzw. praktisch verhindert werden unter Einsparung besonderer Nuten oder ähnlicher Ausnehmungen zur Aufnahme der Dichtung.

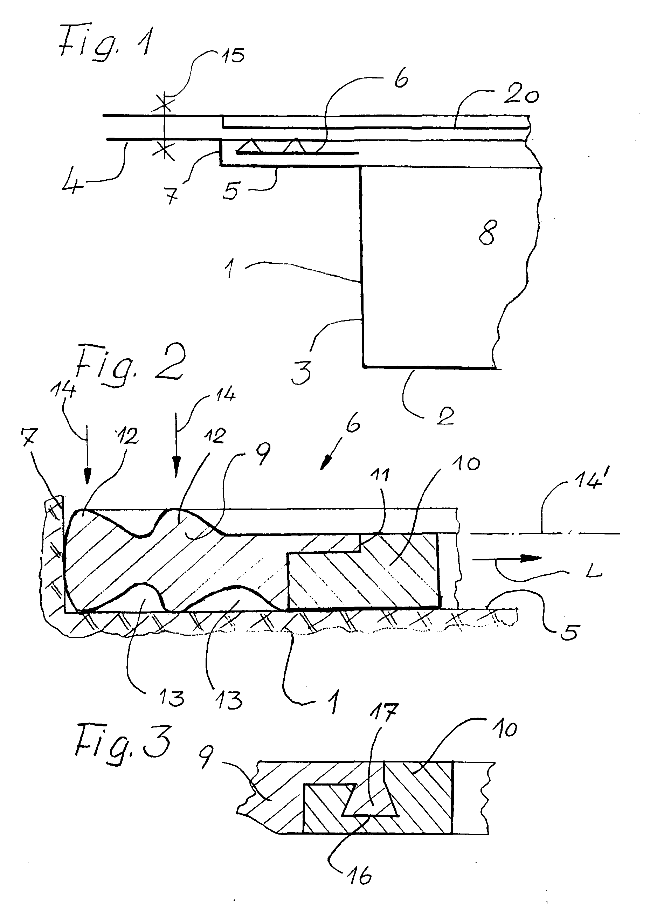

Bei der Ausführung gemäss Fig. 3 ist Querschnittsteil 9 mit einer schwalbenschwanzartigen, sich nach unten hin verbreiternden Umfangsrrippe 17 versehen, die in eine entsprechend hinterschnittene Nut 16 des Querschnittsteils 9 eingreift, um so neben einer festhaftenden Verbindung zwischen den Teilen 9, 10 einen Formschluss zu erreichen; gegebenenfalls kann bei diesem Formschluss aber auch auf eine festhaftende Verbindung verzichtet werden.

## Patentansprüche

1. Verschliessbares, mit einem Deckel versehenes Gehäuse zur Aufnahme elektrischer Elemente, wobei die auf dem Gehäuseunterteil angeordnete, ringförmige, aus einem Elastomer bestehende Dichtung durch Auflegen des Deckels bzw. Schliessen des Gehäuses elastisch verformbar und mit einer oder mehreren vorspringenden Rippen oder Wülsten versehen ist, dadurch gekennzeichnt, daß der mit den Rippen bzw. Wülsten (12) versehene Teil (9) des Querschnitts der Dichtung (6) mit einem Querschnittsteil (10) verbunden ist, der gegenüber dem anderen Querschnittsteil (9) wesentlich härter eingestellt ist, wobei die Rippen bzw. Wülste gegenüber dem härteren Querschnittsteil (10) zur Verformung durch den Deckel (20) beim Verschliessen des Gehäuses vorspringen.

2. Gehäuse nach Anspruch 1, dadurch gekennzeichnet, dass sich der zähharte Querschnittsteil (10) an einem Rand, und zwar vorzugsweise an dem Rand der Dichtung (6) befindet, der dem Inneren (8) des Gehäuses zugekehrt ist.

3. Gehäuse nach Anspruch 1 und 2, dadurch gekennzeichnet, daß sich die Auflagefläche (5) für die Dichtung (6) an der Seite, an der sich der härtere Querschnittsteil (10) befindet, spalt- bzw. stufenlos z.B. bei einer ebenen Auflagefläche eben fortsetzt.

4. Gehäuse nach Anspruch 1, dadurch gekennzeichnet, dass die Unterseite des härter eingestehen Querschnittsteils (10) und die an der Unterseite der Dichtung befindlichen Ausweichräume (13) für den weicher eingestellten Querschnittsteil (9) so ausgeführt sind, dass die die Ausweichräume begrenzenden Vorsprünge und die Unterseite des härter eingestellten Querschnitsteils praktisch in einer Ebene ( ebene Sitzfläche 5 ) angeordnet sind.

5. Gehäuse nach Anspruch 1, dadurch gekennzeichnet, dass die Trennfläche zwischen den beiden Querschnittsteilen (9,10) stufenförmig gestaltet ist ( Stufe 11 ).

6. Gehäuse nach Anspruch 1, dadurch gekennzeichnet, dass der Härteunterschied wenigstens etwa 15 - 35 Shore Grade A beträgt.

7. Gehäuse nach Ansppruch 1, dadurch gekennzeichnet, dass die Härte des härter eingestellten Querschnittsteils (10) etwa 70 - 90 Shore Grade beträgt.

8. Gehäuse nach Anspruch 1, dadurch gekennzeichnet, dass die Querschnittsteile (9,10) festhaftend miteinander verbunden sind.

9. Gehäuse nach Anspruch 1, dadurch gekennzeichnet, dass die Querschnitsteile (9,10) ggfs. unter Verzicht auf eine festhaftende Verbindung formschlüssug miteinander verbunden sind ( Fig. 3 ).

10. Gehäuse nach Anspruch 1, dadurch gekennzeichnet, dass beide Querschnittsteile (9,10) aus einem Elastomer bestehen.

11. Ringförmige Deckelgehäusedichtung für Gehäuse zur Aufnahme elektrischer Elemente nach einem oder mehreren vorhergehenden Ansprüchen.
